(19) Europäisches Patentamt
European Patent Office
Office européen des brevets

(11) **EP 4 066 477 B1**

(12) **EUROPEAN PATENT SPECIFICATION**

(45) Date of publication and mention
of the grant of the patent:
**14.08.2024  Bulletin 2024/33**

(21) Application number: **19954259.8**

(22) Date of filing: **26.11.2019**

(51) International Patent Classification (IPC):
*H04N 23/55* (2023.01)      *H04N 23/63* (2023.01)
*H04N 23/80* (2023.01)      *H04N 25/60* (2023.01)
*G06F 1/16* (2006.01)       *H04M 1/02* (2006.01)
*H04N 7/14* (2006.01)

(52) Cooperative Patent Classification (CPC):
**H04M 1/0264; G06F 1/1686; H04N 7/144;
H04N 23/55; H04N 23/63; H04N 23/80;
H04N 25/60; H10K 59/65;** H04M 1/0266;
H04N 2007/145

(86) International application number:
**PCT/CN2019/121058**

(87) International publication number:
**WO 2021/102705 (03.06.2021 Gazette 2021/22)**

(54) **IMAGING DEVICE AND ELECTRIC DEVICE**

BILDGEBUNGSVORRICHTUNG UND ELEKTRISCHE VORRICHTUNG

DISPOSITIF D'IMAGERIE ET DISPOSITIF ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.10.2022  Bulletin 2022/40**

(73) Proprietor: **GUANGDONG OPPO MOBILE
TELECOMMUNICATIONS
CORP., LTD.
Dongguan, Guangdong 523860 (CN)**

(72) Inventor: **KAMATA, Tetsuji
Yokohama, Kanagawa 220-0012 (JP)**

(74) Representative: **Manitz Finsterwald
Patent- und Rechtsanwaltspartnerschaft mbB
Martin-Greif-Strasse 1
80336 München (DE)**

(56) References cited:
CN-A- 1 883 196          CN-U- 209 267 626
CN-U- 209 590 474        US-A1- 2008 106 628
US-A1- 2014 036 139      US-A1- 2014 192 257
US-A1- 2016 077 640      US-A1- 2017 140 221

EP 4 066 477 B1

## Description

### TECHNICAL FIELD

The present disclosure relates to an imaging device and an electronic device.

### BACKGROUND

Nowadays, a display of an electronic device can be transparent and therefore a camera to take pictures can also be placed behind the display to leave a wider area for the display on a front surface of the electronic device. However, a light from the display to the camera is influenced by optical characteristics of the display. Therefore, if pictures are taken by the camera behind the display, a quality of image of the pictures will be degraded due to the optical disturbance caused by the display.

US 2008/106628 A1 discloses an integrated imaging apparatus for displaying images while capturing images of a scene, and includes an electronic display having an array of display pixels which are used to display image content and at least one image capture device which captures an image, the image capture device having at least an imaging lens and an image sensor array; and the image capture device looks through an aperture in the display, the aperture having at least one partially transparent pixel; and the partially transparent pixels also provide light to display image content.

US 2017/140221 A1 discloses a dual function camera described for infrared and visible light imaging using electrically controlled filters. An example has an image sensor to image visible and infrared light, a lens system to image a scene onto the image sensor, and an electrically activated filter that selectively prevents visible light from the scene from impinging on the image sensor while capturing an infrared image.

US 2014/192257 A1 discloses an electro-optic aperture having a stack that includes a front transparent conductor medium, an active electro-chromic medium and a rear transparent conductor medium. The front and rear transparent conductor mediums are directly connected to each other by a conductive section located within the imaging path. Other embodiments are also described and claimed.

The disturbance is mainly reflection at the display or diffraction due to electrical elements formed in the display. Particularly, the diffraction causes severe ugly artifacts on the image captured by the camera and now there are no effective solutions to resolve this problem.

### SUMMARY

The invention is defined by the independent claim. Advantageous embodiments are set out in the dependent claims. The present disclosure aims to solve at least one of the technical problems mentioned above. Accordingly, the present disclosure needs to provide an imaging device and an electronic device as set out in the appended set of claims.

In the imaging device and the electronic device according to embodiments of the present disclosure, the light from the front side of the display passes through the aperture and reaches the optical lens of the camera. The optical lens focuses the light on the imaging sensor. However, the diffracted light at/in the display is shielded by the shield area of the aperture element. As a result, the diffracted light cannot reach the optical lens and the sharpness of the image captured by the imaging sensor of the camera can be improved. That is, blurring of the image caused by the diffraction and/or internal reflection can be suppressed.

### BRIEF DESCRIPTION OF THE DRAWINGS

These and/or other aspects and advantages of embodiments of the present disclosure will become apparent and more readily appreciated from the following descriptions made with reference to the drawings, in which:

> FIG. 1 is a schematic plan view of an electronic device according to embodiments of the present disclosure;
> FIG. 2 is a cross sectional view taken along line II-II of the electronic device of FIG. 1;
> FIG. 3 is an enlarged partial sectional view of an optical element according to a first embodiment;
> FIG. 4 is an enlarged partial sectional view of an optical element according to a second embodiment;
> FIG. 5 is an enlarged partial sectional view of an optical element according to another example of the second embodiment;
> FIG. 6 is an enlarged partial sectional view of an optical element, an image correction processor and an image signal processor according to one example of a third embodiment;
> FIG. 7 is an enlarged partial sectional view of an optical element, the image correction processor and the image signal processor according to another example of the third embodiment;
> FIG. 8 is an enlarged partial sectional view of an optical element, the image correction processor and the image signal processor according to still another example of the third embodiment; and
> FIG. 9 is a schematic plan view of an electronic device according to a modification of the first through third embodiments.

### DETAILED DESCRIPTION

Embodiments of the present disclosure will be described in detail and examples of the embodiments will be illustrated in the accompanying drawings. The same or similar elements and the elements having same or similar functions are denoted by like reference numerals throughout the descriptions. The embodiments described herein with reference to the drawings are explanatory, which aim to illustrate the present disclosure, but shall not be construed to limit the present disclosure.

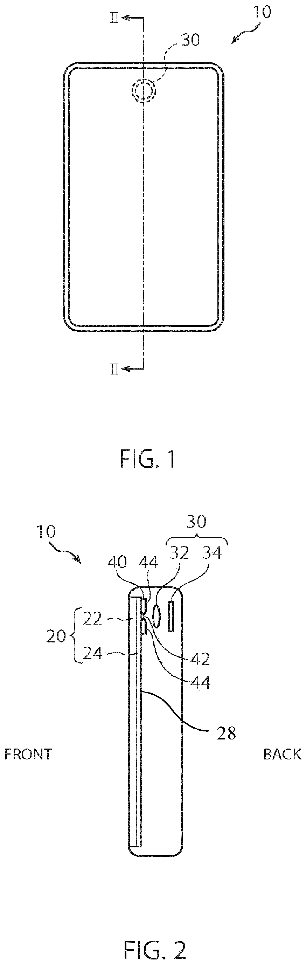

FIG. 1 illustrates an electronic device 10 according to embodiments of the present disclosure and FIG. 2 illustrates a cross sectional view taken along line II-II of the electronic device of FIG. 1. In other words, FIG. 1 illustrates a layout of a front view of the electronic device 10.

As shown in FIGS. 1 and 2, the electronic device 10 includes a display 20, a camera 30 and an aperture element 40 which is attached to the display 20. In other words, the aperture element 40 is located between the display 20 and the camera 30. In some embodiments, the aperture element 40 may be further spaced apart from the camera 30.

Hereinafter, a front side indicates a side in which an object to be captured by the camera 30 is located and a back side indicates a side in which the camera 30 is located. In addition, a front surface 27 of the display 20 is a surface of the front side of the display 20 and a back surface 28 of the display 20 is a surface of the back side of the display 20.

Similarly, a front surface of the aperture element 40 indicates a surface of the front side of the aperture element 40 and a back surface of the aperture element 40 indicates a surface of the back side of the aperture element 40.

Similarly, a front surface 36 of the camera 30 indicates a surface of the front side of the camera 30 and a back surface of the camera 30 indicates a surface of the back side of the camera 30.

Similarly, a front surface of the electronic device 10 indicates a surface of the front side of the electronic device 10 and a back surface of the electronic device 10 indicates a surface of the back side of the electronic device 10.

Therefore, more precisely, the aperture element 40 is inserted between the back surface 28 of the display 20 and the front surface 36 of the camera 30, and spaced apart from the front surface 36 of the camera 30. The display 20, the camera 30 and the aperture element 40 constitute an imaging device 100 in the embodiments of the present disclosure. Of course, the imaging device 100 may include any elements other than the display 20, the camera 30 and the aperture element 40.

In the embodiments of the present disclosure, the electronic device 10 is a mobile device, particularly a smartphone device. However, the electronic device 10 may be various kinds of devices such a multifunctional mobile device, a laptop computer, a desktop computer, a tablet computer and so on.

The display 20 may be made of organic light emitting diodes (OLED) in the embodiment. The display 20 is substantially transparent and covers substantially all area of the front surface of the electronic device 10. In other words, the display 20 covers almost the entire front surface of the electronic device 10 and it is so called a full cover display or an under-display camera.

The display 20 may include a plurality of electrical elements such as switching elements, light emitting elements, capacitors, wires, and so on. Moreover, the display 20 may include a plurality of layers. In the example of the electronic device 10 shown in FIGS. 1 and 2, the display 20 includes a first layer 22 and a second layer 24. For example, the first layer 22 is a light emitting layer 22 and the second layer 24 is a wiring layer. However, more layers may be included in the display 20 in the embodiments of the present disclosure. Each layer of the first layer 22 and the second layer 24 includes a plurality of electrical elements.

The display 20 is not limited to a display formed of the organic light emitting diodes but may be formed of other kinds of transparent display such as a liquid crystal display (LCD) or the like.

The camera 30 is located behind the display 20. In other words, the camera 30 is embedded under the display 20. Therefore, the camera 30 is an embedded camera invisible for users of the electronic device 10. The camera 30 may be placed anywhere under the display 20. In the embodiments, the camera is located at the back side of the display 20 and located at the center of an upper area of the electronic device 10 of FIG. 1.

The camera 30 includes an optical lens 32 and an imaging sensor 34. The optical lens 32 are disposed between the imaging sensor 34 and the aperture element 40, and spaced apart from the aperture element 40. The optical lens 32 may include one or more lenses. In the example of the electronic device 10 in FIGS. 1 and 2, one lens is depicted as the optical lens 32. The optical lens 32 gathers the light which has passed through the display 20 and focuses the light on the imaging sensor 34. The imaging sensor 34 senses the light to create an image.

Moreover, the electronic device 10 according to the invention further includes an aperture element 40 which is attached to the display 20 and located between the display 20 and the camera 30 as mentioned above. The aperture element 40 includes an aperture 42 and a shield area 44. The shield area 44 is a portion of the aperture element 40 where the aperture 42 is not formed. In other words, the shield area 44 is a remaining part of the aperture element 40 with the aperture 42. The light passing through the display 20 can pass through the aperture 42 but cannot pass the shield area 44. After the light has passed through the aperture 42 of the aperture element 40, the light reaches the camera 30. That is, the light reaches the optical lens 32 of the camera 30. As a result, the camera 30 can create the image of the picture based on the light having reached the camera 30.

[First embodiment]

In a first embodiment of the present disclosure, the imaging device 100 of the electronic device 10 is configured to include the aperture element 40 attached to the back surface 28 of the display 20. The aperture element 40 is further spaced apart from the front surface 36 of the camera 30. That is, no aperture element 40 is provided on the front surface 36 of the camera 30. More details will be described below.

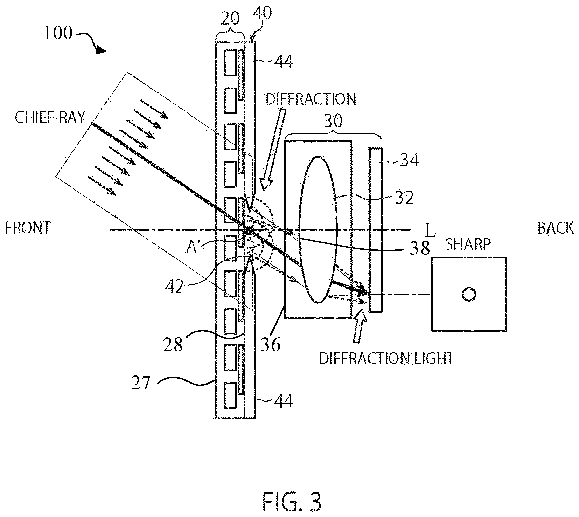

FIG. 3 illustrates an enlarged cross sectional view of the imaging device 100 including the display 20, the camera 30 and the aperture element 40 of the electronic device 10 according to the first embodiment. That is, FIG. 3 is a partially enlarged view of the electronic device 10 in FIG. 2.

As shown in FIG. 3, each of the electrical elements in the display 20 has different optical characteristics which cause diffraction and internal reflection at/in the display 20. For example, the electrical elements in the display 20 have different refractive indexes. Therefore, the light passing through the display 20 from the front side to the back side of the display 20 diffracts due to the different refractive indexes in the display 20 and/or at the display 20. Also, an internal reflection is generated in the display 20 due to the different refractive indexes.

The aperture element 40 has the aperture 42 which is a hole through which the light can pass. In some embodiments, the optical lens 32 may be disposed correspondingly to the aperture 42, or a projection of the optical lens 32 projected on the aperture element 40 may cover the aperture 42. In this way, the light passing through the aperture 42 may enter the optical lens 32. The aperture element 40 also has the shield area 44 which is an area of the aperture element 40 other than the aperture 42. The shield area 44 can shield the light from the display 20 and the light is blocked by the shield area 44. Therefore, the light cannot pass the shield area 44 to the camera 30.

In addition, the aperture 42 may have a circular shape in the first embodiment. That is, in a front view of the electronic device 10 according to the first embodiment, the shape of the aperture 42 can be circular and the light from the front side of the electronic device 10 can pass through the aperture 42 of the circular shape.

In the electronic device 10 according to the first embodiment, the aperture element 40 may be formed of mechanical parts such as an aperture plate. For example, the mechanical parts are made of steel, plastic, rubber and so on which are capable of shielding the light from the display 20 and in which the aperture 42 can be made. In some embodiments, the aperture 42 may be a through hole defined in the mechanical parts. In the example of FIG. 3, the aperture 42 is made at the middle area of the aperture element 40. However, the aperture 42 can be made in any area of the aperture element 40.

For example, the aperture element 40 may be attached to the display 20 by an adhesive. In this case, the aperture element 42 is attached to the back surface 28 of the display 20 via the hardened adhesive. Otherwise, the aperture element 40 may be attached to the display 20 by a double sided tape. In this case, the aperture element 40 is attached to the back surface 28 of the display 20 via the double sided tape.

In another example of the first embodiment, the aperture element 40 may be formed by a direct printing technology on the back surface 28 of the display 20. That is, the aperture element 40 including the aperture 42 and the shield area 44 can be printed on the back surface 28 of the display 20 by the direct printing technology. The direct printing technology can also be referred to a 3D print technology and printing materials capable of shielding the light are needed to print the aperture element 40 on the back side of the display 20. In this case, the aperture element 40 is directly attached to the back surface 28 of the display 20.

A diaphragm position A' is a center of the aperture 42 of the aperture element 40. That is, the diaphragm position A' for the optical lens 32 is located at the center of the aperture 42 of the aperture element 40 which is attached to the back surface 28 of the display 20. The camera 30 is designed so that the diaphragm position A' of the optical lens 32 is positioned at the center of the aperture 42 of the aperture element 40 attached to the back surface 28 of the display 20. In addition, the diaphragm position A' is on an optical axis L of the camera 30, i.e. the optical lens 32 of the camera 30.

A chief ray of the light from the front side to the back side of the display 20 always passes the diaphragm position A'. That is, although one chief ray of the light is depicted in FIG. 3, the chief ray from various directions definitely passes the diaphragm position A'.

According to the imaging device 100 of the electronic device 10 of the present embodiment, when the light passes through the display 20 from the front side to the back side, the diffraction may occur at/in the display 20 due to the different optical characteristics of the display 20. However, the diffracted light is blocked by the shield area 44 of the aperture element 40. Therefore, an image created by the imaging sensor 34 of the camera 30 can be sharp. That is, blurring of the image caused by the diffraction and/or internal reflection can be suppressed.

In other words, the light from the front side of the display 20 passes through the aperture 42 and reaches the optical lens 32 of the camera 30. The optical lens 32 focuses the light on the imaging sensor 34. However, the diffracted light at/in the display 20 is shielded by the shield area 44 of the aperture element 40. As a result, the diffracted light cannot reach the optical lens 32 and the sharpness of the image captured by the imaging sensor 34 of the camera 30 can be improved.

In a strict sense, a small amount of the diffracted light in the aperture 42 may reach the optical lens 32 and the imaging sensor 34 of the camera 30. However, since the amount of the diffracted light at/in an area of the display 20 corresponding to the aperture 42 is extremely small, its influence on the image captured by the imaging sensor 34 can be negligible.

[Second embodiment]

Although no aperture element is provided on the front surface 36 of the camera 30 in the first embodiment, an additional aperture element is provided on the front surface 36 of the camera 30 in a second embodiment. Hereinafter, differentials from the first embodiment will be explained.

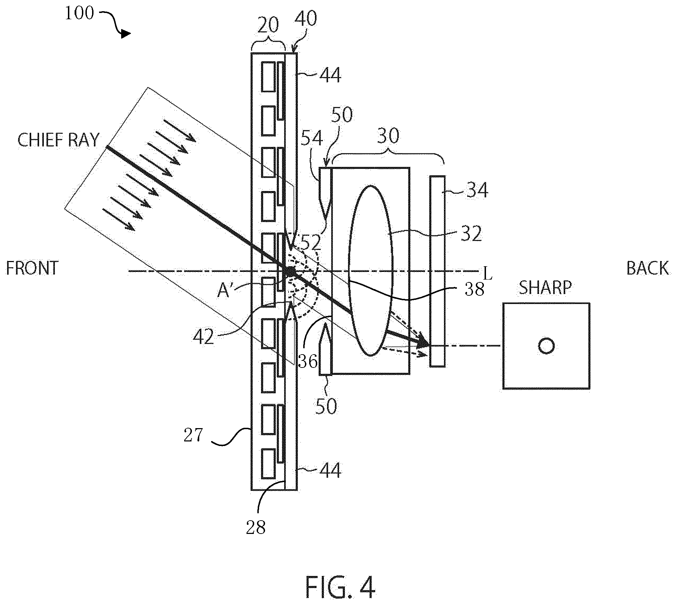

FIG. 4 illustrates an enlarged cross sectional view of the imaging device 100 including the display 20, the camera 30 and the aperture element 40 of the electronic device 10 according to the second embodiment. That is, FIG. 4 is a partially enlarged view of the electronic device 10 in FIG. 2 and corresponds to FIG. 3 of the first embodiment.

As shown in FIG. 4, the imaging device 100 according the second embodiment further includes an additional aperture element 50 provided with the camera 30, and the additional aperture element 50 may be spaced apart from the aperture element 40. More specifically, the additional aperture element 50 is attached to the front surface 36 of the camera 30 which is a surface of the front side of the camera 30. In other words, the additional aperture element 50 is attached to a front surface 38 of the optical lens 32 of the camera 30. Therefore, the additional aperture element 50 intervenes between the aperture element 40 and the optical lens 32 of the camera 30.

The additional aperture element 50 also has an additional aperture 52 which is a hole through which the light can pass. The additional aperture element 50 also has an additional shield area 54 which is an area of the additional aperture element 50 other than the additional aperture 52. The additional shield area 54 can shield the light passing through the aperture 42 of the aperture element 40 from the display 20. Thus, the light is blocked by the additional shield area 54.

In addition, the additional aperture 52 may have a circular shape in the second embodiment. That is, in a front view of the electronic device 10 according to the second embodiment, the shape of the additional aperture 52 is circular and the light passing through the aperture 42 of the aperture element 40 from the front side of the electronic device 10 can pass through the additional aperture 52 of the circular shape to the optical lens 32 of the camera 30. In the present embodiment, as shown in FIG. 4, a size of the additional aperture 52 can be greater than a size of the aperture 42, and a diaphragm position A' of the optical lens is located at a center of the aperture 42 of the aperture element 40 in this case.

Similarly to the imaging device 100 of the electronic device 10 of the first embodiment mentioned above, the additional aperture element 50 may be formed of mechanical parts or by the direct printing technology. Incidentally, the additional aperture element 50 may have the same structure as the aperture element 40 or may have a different structure from the aperture element 40.

According to the imaging device 100 of the electronic device 10 of the present embodiment, the diffracted light is blocked by the shield area 44 of the aperture element 40 in the same manner as that in the first embodiment. Furthermore, the diffracted light passing through the aperture 42 of the aperture element 40 can be blocked by the additional shield area 54 of the additional aperture element 50. Therefore, the sharpness of the image generated by the imaging sensor 34 can be further improved.

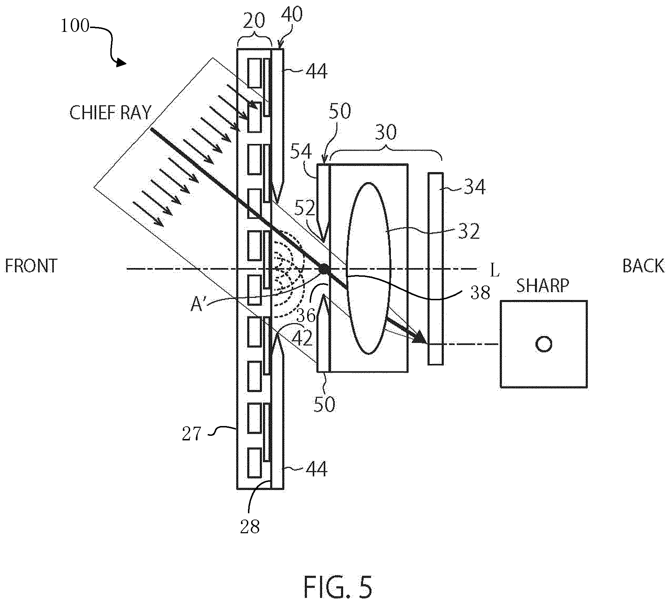

Incidentally, in the imaging device 100 of the electronic device 10 according to the second embodiment, as shown in FIG. 5, the diaphragm position A' may be moved to and located at a center of the additional aperture 52 of the additional aperture element 50 and further disposed on the optical axis L of the optical lens 32. In this case, the size of the additional aperture 52 can be smaller than a size of the aperture 42. Even in the structure of the imaging device 100 shown in FIG. 5, the diffracted light at/in the display 20 can be blocked by the aperture element 40 and the additional aperture element 50. That is, the shield area 44 of the aperture element 40 can shield most of the diffracted light and the additional shield area 54 of the additional aperture element 50 can shield the rest of the diffracted light. Therefore, the sharpness of the image generated by the imaging sensor 34 can be improved.

[Third embodiment]

The aperture element 40 is attached to the back surface 28 of the display 20 by means of various ways. Therefore, a consideration to a thickness of an intervening element between the back surface 28 of the display 20 and the front surface of the aperture element 40 may be needed.

Moreover, in order to prevent the diffraction of the light from the front side to the back side of the display 20 more efficiently, the diffraction in an area of the display 20 corresponding to the aperture 42 of aperture element 40 should be suppressed as much as possible.

Therefore, in the third embodiment, the conditions of an arrangement of the display 20, the camera 30 and the aperture element 40 and the measures aiming to suppress the diffraction in the area of the display 20 corresponding to the aperture 42 will be discussed.

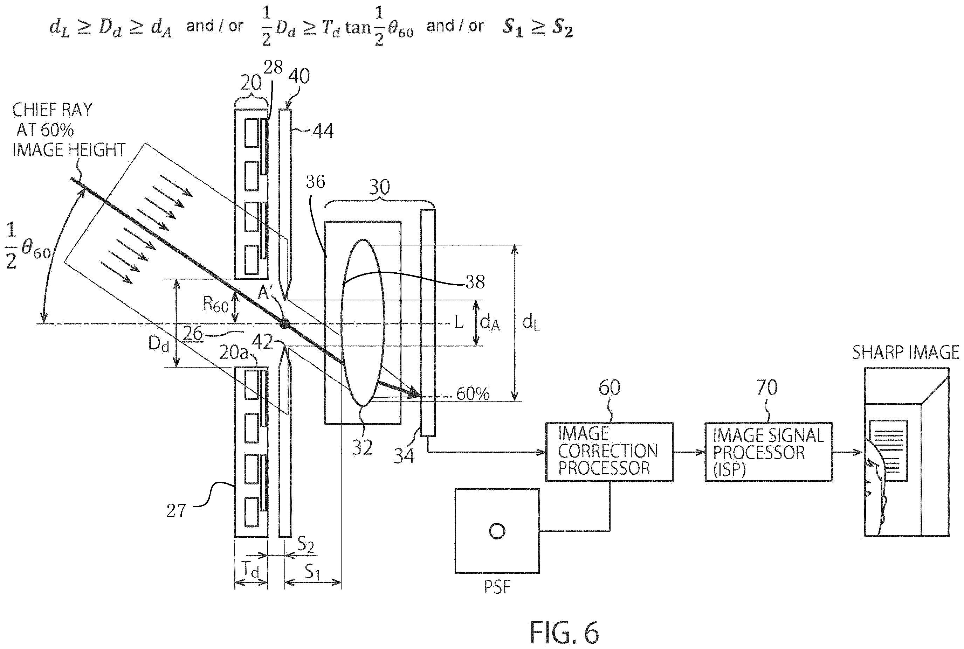

In an example of the imaging device 100 shown in FIG. 6, a hole 20a is formed in the display 20. More specifically, the hole 20a is formed in an area of the display 20 which corresponds to the aperture 42 of the aperture element 40. The hole 20a forms a non-display area 26 of the display 20 in this example.

In other words, the hole 20a is located in the area of the display 20 in the front side of the aperture 42 of the aperture element 40 and in the front side of the optical lens 32 of the camera 30. The hole 20a has a circular shape in the front view of the electronic device 10 and a diameter of the hole 20a is defined as $D_d$. The diameter $D_d$ of the hole 20a is small enough. Therefore, its defective image displayed on the display 20 due to the hole 20a is small enough for a user of the electronic device 10.

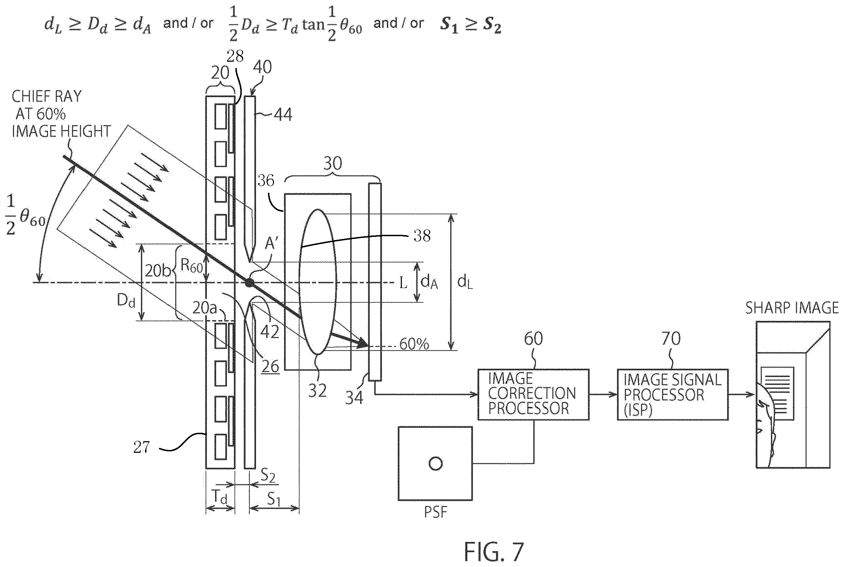

In another example of the imaging device 100 shown in FIG. 7, the hole 20a is filled with a light transmission material like a semi-transparent material or a transparent material. For example, the hole 20a is filled with clear glass, ground glass, clear plastic and so on. In this example, the hole 20a has also a circular shape in the front view of the electronic device 10 and the diameter of the hole 20a is also defined as $D_d$. The hole 20a also forms the non-display area 26 of the display 20 of this example. No electrical elements are formed in the non-display area 26.

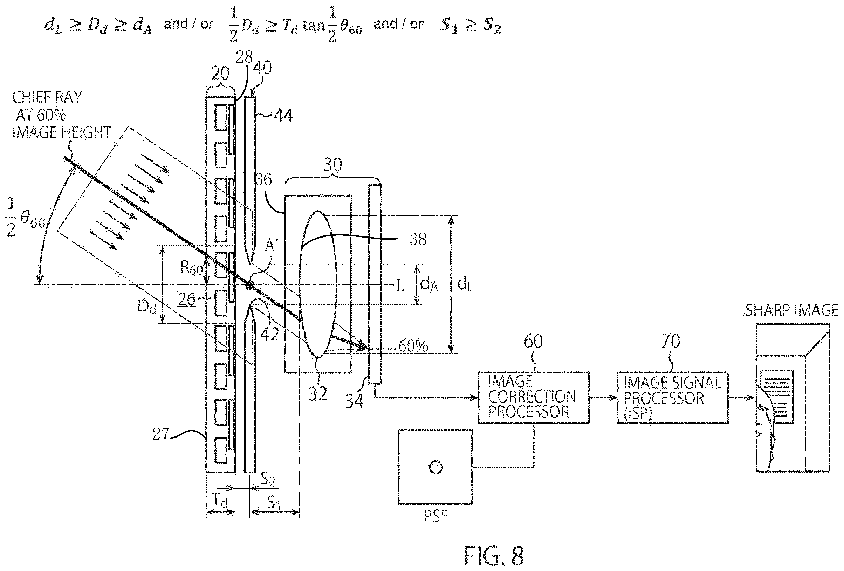

In still another example of the imaging device 100 shown in FIG. 8, the electrical elements are formed also in the non-display area 26 in the same manner as the area other than the non-display area 26. The electrical elements in the non-display area 26 are turn on their display function and work as a part of the display 20 during a normal situation that is a situation except when the imaging device 100 captures the image. On the other hand, the electrical elements in the non-display area 26 are turned off their display function and do not work as the part of the display 20 when the imaging device 100 captures the image. That is, the electrical elements in the non-display area 26 do not function as the display 20 when capturing the image whereas the electrical elements in the non-display area 26 do function as the display 20 except when capturing the image. As a result, no light is emitted from the electrical elements formed in the non-display area 26 when the camera 30 generates the image.

Also in this example, the non-display area 26 has a circular shape in the front view of the electronic device 10 and the diameter of the non-display area 26 is defined as $D_d$.

The technique of the examples shown in FIGS. 6-8 may be applied to the imaging device 100 of the electronic device 10 according to both the first embodiment and the second embodiment. That is, in the first embodiment and the second embodiment, the display 20 does not have the non-display area 26 when the imaging device 100 captures the image. However, the imaging device 100 of the first embodiment and the second embodiment may include display 20 with the non-display area 26 which does not function when capturing the image so that the light is not emitted from the electrical elements in the non-display area 26.

Furthermore, the imaging device 100 of the electronic device 10 according to the third embodiment shown in FIGS. 6-8 satisfies at least one of the conditions mentioned below.

Condition 1)

If an effective diameter of a smallest lens of the optical lens 32 is $d_L$ and a diameter of the aperture 42 of the aperture element 40 is $d_A$, then the condition of $d_L \geq$ $D_d \geq d_A$ should be satisfied.

As mentioned above, the optical lens 32 may include a plurality of optical lens and the effective diameter of the smallest lens among the lens in the optical lens 32 defines $d_L$. Normally, the smallest lens is located at the most front side of the lens 32. Namely, the smallest lens is the nearest one to the aperture 42 of the aperture element 40.

If the condition is satisfied, the diameter $d_A$ of the aperture 42 of the aperture element 40 is the smallest diameter whereas the effective diameter $d_L$ of the smallest lens of the optical lens 32 is the largest diameter.

Condition 2)

If an angle of view at 60% image height is $\theta_{60}$ and a distance between the diaphragm position A' (the center of the aperture 42) and the front surface 27 of the display 20 is $T_d$, then the condition of

$$\frac{1}{2}D_d \geq T_d \tan\frac{1}{2}\theta_{60}$$

should be satisfied.

For example, if a diagonal line of the image of the camera 30 is 8 mm, then 100% image height is 4 mm and 60% image height is 2.4 mm from a cross point of two diagonal lines of the image. $T_d \tan\dfrac{1}{2}\theta_{60}$ is a radius $R_{60}$ of the front surface 27 of the display 20 and indicates a distance from the optical axis L to a cross point of the chief ray at 60% image height and the front surface 27 of the display 20.

If the condition is satisfied, then the chief ray can pass through the non-display area 26 at least between 0% and 60% image height. Therefore, an area of the image at least within the 60% image height can be sharp and clear. On the other hand, an area of the image out of the 60% image height might be blurred because the chief ray passes an area including the electrical elements of display 20. However, the area of the image outside of the 60% image height is not so important for a user and an impression of a quality of the image is not significantly influenced.

Condition 3)

If $S_1$ is a distance between the diaphragm position A' (the center of the aperture 42) and the front surface 38 of the optical lens 32 and $S_2$ is a distance between the diaphragm position A' (the center of the aperture 42) and the back surface 28 of the display 20, then the condition of $S_1 \geq S_2$ should be satisfied.

$S_2$ is the thickness of the hardened adhesive, the thickness of the double sided tape and so on between the back surface 28 of the display 20 and the front surface of the aperture element 40. A mechanical intervening element like a positioning member may be inserted between the back surface 28 of the display 20 and the front surface of the aperture element 40. In this case, $S_2$ is the thickness of the mechanical intervening element. On the other hand, if the aperture element 40 is printed on the back surface 28 of the display 20 by the direct printing technology, $S_2$ is substantially zero.

The imaging device 100 of the electronic device 10 according to the third embodiment shown in FIGS. 6-8 satisfies the condition 1) and/or the condition 2) and/or the condition 3). In other words, the imaging device 100 according to the third embodiment satisfies at least one of the conditions 1) through 3).

Furthermore, the electronic device 10 according to the third embodiment shown in FIGS. 6-8 further includes an image correction processor 60 and an image signal processor 70. The image correction processor 60 is circuitry to restore the image captured by the imaging sensor 34 by using optical characteristics of the display 20 and of the optical lens 32. The image signal processor 70 is circuitry to process image data obtained from the image correction processor 60 and execute a noise reduction process, a defect correction process, a white balance process and so on for the image data.

More specifically, the sharpness of the image would be degraded due to the display 20 and/or the optical lens 32. In the third embodiment, the image correction process of the image correction processor 60 restores the degraded image to improve sharpness.

During the image correction process, in order to improve the sharpness of the image generated by the camera 30, a sharpening process is executed by using PSF (Point Spread Function) which is also called as an inverse filtering process. In more detail, the image correction processor 60 may execute an image sharpening process based on the optical characteristics of the display 20 and/or the optical lens 32 which can be represented by PSF. The blurring of the image captured by the camera 30 can be improved by the image sharpening process. For example, the image sharpening process emphasizes edges of the image by using an inverse filter which is made from the PSF based on the optical characteristics of the display 20 and/or the optical lens 32. In addition, during the image correction process, in order to improve the brightness of the image generated by the camera 30, a global contrast adjustment is also executed.

The image correction processor 60 and/or the image signal processor 70 may be placed either inside the electronic device 10 or outside the electronic device 10. When the image correction processor 60 and/or the image signal processor 70 is inside the electronic device 10, the image correction processor 60 and/or the image signal processor 70 may be incorporated in the electronic device 10.

When the image correction processor 60 and/or the image signal processor 70 is outside the electronic device 10, a computer connected to the electronic device 10 may execute the image correction process. In this case, the computer connected to the electronic device 10 constitutes the image correction processor 60 and/or the image signal processor 70.

In the third embodiment of the present disclosure, the image correction processor 60 is not always necessarily needed. That is, the image correction processor 60 may be omitted in the third embodiment of the present disclosure. For example, if the degradation of the image captured by the imaging sensor 34 is not so strong and the quality of the image is good enough for users, the image correction processor 60 can be omitted.

[Modification of First, Second and Third embodiments]

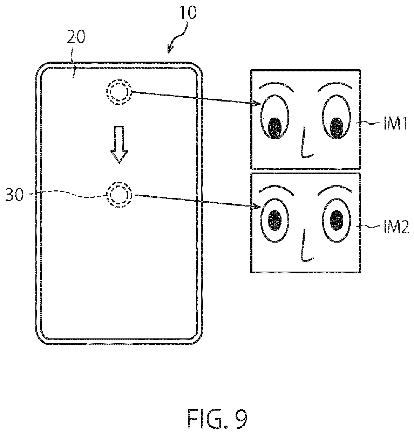

Since the display 20 is composed of a substantially transparent display, the camera 30 can be placed anywhere in the electronic device 10. For example, as shown in FIG. 9 which illustrates a plan view of the electronic device 10 according to a modification of the first, second and third embodiments and which corresponds to FIG. 1, the camera 30 may be placed in a middle area of the electronic device 10. Especially, in the present modification, the camera 30 is placed at the center of the electronic device 10.

In accordance with the electronic device 10 according to the first through third embodiments, the camera 30 can be mounted behind the display 20 without ugly artifacts caused by the diffraction. This enables the user to set the camera 30 anywhere behind the display 20, and this makes it possible to take natural eye point selfie without any costly computation.

More specifically, if the camera 30 is mounted in an upper area of the electronic device 10 as shown in FIG. 1, the eye point of the selfie image IM1 is not natural as shown in FIG. 9. On the other hand, if the camera 30 is mounted in the middle area of the electronic device 10 as shown in FIG. 9, the eye point of the selfie image IM2 can be natural. Here, the middle area does not necessarily mean that the camera 30 is mounted at the center of the electronic device 10. That is, the camera 30 may be placed at around the center of the electronic device 10 in order to obtain the selfie image IM2 with natural eye point. In other words, the middle area means an area including the center of the electronic device 10 and a peripheral area of the center of the electronic device 10. A distance between eye positions of a displayed face and the camera 30 in a case where the camera 30 is placed in the middle area is smaller than that in a case where the camera 20 is placed in the upper area of the electronic device 10. Therefore, the user of the electronic device 10 can easily take a selfie image with natural eye point.

Moreover, the electronic device 10 of FIG. 9 is a type of a full covered display smartphone. There is no area to allocate the camera 30 on the front surface 27 of the display 20, and thus a wider area for the display 20 can be created on the front surface of the electronic device 10.

In the description of embodiments of the present disclosure, it is to be understood that terms such as "central", "longitudinal", "transverse", "length", "width", "thickness", "upper", "lower", "front", "rear", "left", "right", "vertical", "horizontal", "top", "bottom", "inner", "outer", "clockwise" and "counterclockwise" should be construed to refer to the orientation or the position as described or as shown in the drawings under discussion. These relative terms are only used to simplify description of the present disclosure, and do not indicate or imply that the device or element referred to must have a particular orientation, or constructed or operated in a particular orientation. Thus, these terms cannot be constructed to limit the present disclosure.

In addition, terms such as "first" and "second" are used herein for purposes of description and are not intended to indicate or imply relative importance or significance or to imply the number of indicated technical features. Thus, the feature defined with "first" and "second" may comprise one or more of this feature. In the description of the present disclosure, "a plurality of" means two or more than two, unless specified otherwise.

In the description of embodiments of the present disclosure, unless specified or limited otherwise, the terms "mounted", "connected", "coupled" and the like are used broadly, and may be, for example, fixed connections, detachable connections, or integral connections; may also be mechanical or electrical connections; may also be direct connections or indirect connections via intervening structures; may also be inner communications of two elements, which can be understood by those skilled in the art according to specific situations.

In the embodiments of the present disclosure, unless specified or limited otherwise, a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on", "above" or "on top of" a second feature may include an embodiment in which the first feature is right or obliquely "on", "above" or "on top of" the second feature, or just means that the first feature is at a height higher than that of the second feature; while a first feature "below", "under" or "on bottom of" a second feature may include an embodiment in which the first feature is right or obliquely "below", "under" or "on bottom of" the second feature, or just means that the first feature is at a height lower than that of the second feature.

Various embodiments and examples are provided in the above description to implement different structures of the present disclosure. In order to simplify the present disclosure, certain elements and settings are described in the above. However, these elements and settings are only by way of example and are not intended to limit the present disclosure. In addition, reference numbers and/or reference letters may be repeated in different examples in the present disclosure. This repetition is for the purpose of simplification and clarity and does not refer to relations between different embodiments and/or settings. Furthermore, examples of different processes and materials are provided in the present disclosure. However, it would be appreciated by those skilled in the art that other processes and/or materials may be also applied.

Reference throughout this specification to "an embodiment", "some embodiments", "an exemplary embodiment", "an example", "a specific example" or "some examples" means that a particular feature, structure, material, or characteristics described in connection with the embodiment or example is included in at least one embodiment or example of the present disclosure. Thus, the appearances of the above phrases throughout this specification are not necessarily referring to the same embodiment or example of the present disclosure. Furthermore, the particular features, structures, materials, or characteristics may be combined in any suitable manner in one or more embodiments or examples.

Any process or method described in a flow chart or described herein in other ways may be understood to include one or more modules, segments or portions of codes of executable instructions for achieving specific logical functions or steps in the process, and the scope of a preferred embodiment of the present disclosure includes other implementations, in which it should be understood by those skilled in the art that functions may be implemented in a sequence other than the sequences shown or discussed, including in a substantially identical sequence or in an opposite sequence.

The logic and/or step described in other manners herein or shown in the flow chart, for example, a particular sequence table of executable instructions for realizing the logical function, may be specifically achieved in any computer readable medium to be used by the instruction execution system, device or equipment (such as the system based on computers, the system comprising processors or other systems capable of obtaining the instruction from the instruction execution system, device and equipment and executing the instruction), or to be used in combination with the instruction execution system, device and equipment. As to the specification, "the computer readable medium" may be any device adaptive for including, storing, communicating, propagating or transferring programs to be used by or in combination with the instruction execution system, device or equipment. More specific examples of the computer readable medium comprise but are not limited to: an electronic connection (an electronic device) with one or more wires, a portable computer enclosure (a magnetic device), a random access memory (RAM), a read only memory (ROM), an erasable programmable read-only memory (EPROM or a flash memory), an optical fiber device and a portable compact disk read-only memory (CDROM). In addition, the computer readable medium may even be a paper or other appropriate medium capable of printing programs thereon, this is because, for example, the paper or other appropriate medium may be optically scanned and then edited, decrypted or processed with other appropriate methods when necessary to obtain the programs in an electric manner, and then the programs may be stored in the computer memories.

It should be understood that each part of the present disclosure may be realized by the hardware, software, firmware or their combination. In the above embodiments, a plurality of steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a programmable gate array (PGA), a field programmable gate array (FPGA), etc.

Those skilled in the art shall understand that all or parts of the steps in the above exemplifying method of the present disclosure may be achieved by commanding the related hardware with programs. The programs may be stored in a computer readable storage medium, and the programs comprise one or a combination of the steps in the method embodiments of the present disclosure when run on a computer.

In addition, each function cell of the embodiments of the present disclosure may be integrated in a processing module, or these cells may be separate physical existence, or two or more cells are integrated in a processing module. The integrated module may be realized in a form of hardware or in a form of software function modules. When the integrated module is realized in a form of software function module and is sold or used as a standalone product, the integrated module may be stored in a computer readable storage medium.

The storage medium mentioned above may be read-only memories, magnetic disks, CD, etc.

**Claims**

1. An imaging device (100), comprising:

   a display (20);
   a camera (30) located at a back side of the display (20), the camera (30) comprising an optical lens (32) and an imaging sensor (34) to sense light through the display (20) to capture an image; and
   an aperture element (40) attached to a back surface (28) which is a surface of the back side of the display (20), wherein the aperture element (40) has an aperture (42) through which the light from the display (20) passes, and the light passing the aperture (42) reaches the camera (30);

   **characterized in that** the imaging device (100) comprises an additional aperture element (50) on a front surface (36) which is a surface of a front side of the camera (30), wherein the additional aperture element (50) has an additional aperture (52) through which a part of the light passing through the aperture (42) passes and an additional shield area (54) configured to shield the rest part of light passing through the aperture (42), and the part of light passing the additional aperture (52) reaches the camera (30).

2. The imaging device (100) according to claim 1, wherein the aperture element (40) comprises a shield area (44) which shields the light passing from a front side of the display (20) to the back side of the display (20), wherein the shield area (44) is a portion of the aperture element (40) where the aperture (42) is not formed.

3. The imaging device (100) according to claim 1 or 2, wherein the aperture element (40) is formed of mechanical parts, and the aperture (42) is a hole defined in the mechanical parts.

4. The imaging device (100) according to any one of claims 1 to 3, wherein the aperture element (40) is attached to the back surface (28) of the display (20) via a hardened adhesive or a double sided tape.

5. The imaging device (100) according to any one of claims 1 to 3, wherein the aperture element (40) is directly printed on the back surface (28) of the display (20).

6. The imaging device (100) according to any one of claims 1 to 5, wherein a diaphragm position (A') of the optical lens (32) is located at a center of the aperture (42) of the aperture element (40).

7. The imaging device (100) according to any one of claims 1 to 6, wherein the aperture element (40) is spaced apart from a front surface (36) which is a surface of a front side of the camera (30).

8. The imaging device (100) according to any one of claims 1 to 5, wherein a diaphragm position (A') of the optical lens (32) is located at a center of the aperture (42) of the aperture element (40), and a size of the additional aperture (52) is greater than a size of the aperture (42); or a diaphragm position (A') of the optical lens (32) is located at a center of the additional aperture (52) of the additional aperture element (50), and a size of the additional aperture (52) is smaller than a size of the aperture (42).

9. The imaging device (100) according to any one of claims 1 to 8, wherein the display (20) has a hole (20a) in an area corresponding to the aperture (42) of the aperture element (40).

10. The imaging device (100) according to any one of claims 1 to 9, wherein the display (20) has a non-display area (26) without electrical elements arranged therein, and the non-display area (26) corresponds to the aperture (42) of the aperture element (40).

11. The imaging device (100) according to any one of claims 1 to 9, wherein the display (20) has a non-display area (26) corresponding to the aperture (42) of the aperture element (40), and the display (20) comprises a plurality of electrical elements, and a display function of the electrical elements in the non-display area (26) is turned off in response to the camera (30) capturing the image.

12. The imaging device (100) according to any one of claims 1 to 11, wherein the camera (30) is placed in a middle area of the display (20).

13. The imaging device (100) as claimed in any one of claims 1 to 9, wherein the display (20) has a non-display area (26) corresponding to the aperture (42) of the aperture element (40); and
wherein the imaging device (100) satisfies at least one of the following conditions:

1) the condition of $d_L \geq D_d \geq d_A$, where an effective diameter of a smallest lens of the optical lens (32) is $d_L$, a diameter of the non-display area (26) is $D_d$, and a diameter of the aperture (42) of the aperture element (40) is $d_A$,

2) the condition of $\dfrac{1}{2} D_d \geq T_d \tan \dfrac{1}{2} \theta_{60}$ ,
where an angle of view at 60% image height is $\theta_{60}$ and a distance between a center of the aperture (42) and a front surface (27) which is a surface of a front side of the display (20) is $T_d$, and

3) the condition of $S_1 \geq S_2$, where $S_1$ is a distance between the center of the aperture (42) and a front surface (38) which is a surface of the front side of the optical lens (32) and $S_2$ is a distance between the center of the aperture (42) and the back surface (28) of the display (20).

14. An electronic device (10), **characterized by** comprising:

the imaging device (100) according to any one of claims 1 to 13; and
an image correction processor (60), configured to correct the image captured by the camera (30).

**Patentansprüche**

1. Bildgebungsvorrichtung (100), umfassend:

eine Anzeige (20);
eine Kamera (30), die sich auf einer Rückseite der Anzeige (20) befindet, die Kamera (30) umfassend eine optische Linse (32) und einen Bildgebungssensor (34) zum Erfassen von Licht durch die Anzeige (20) zum Aufnehmen eines Bilds; und
ein Öffnungselement (40), das an einer Rückfläche (28) angebracht ist, die eine Oberfläche der Rückseite der Anzeige (20) ist, wobei das Öffnungselement (40) eine Öffnung (42) aufweist, durch die das Licht von der Anzeige (20) hindurchgeht, und das Licht, das durch die Öffnung (42) hindurchgeht, die Kamera (30) erreicht;
**dadurch gekennzeichnet, dass** die Bildgebungsvorrichtung (100) ein zusätzliches Öffnungselement (50) an einer Vorderfläche (36) umfasst, die eine Oberfläche einer Vorderseite der Kamera (30) ist, wobei das zusätzliche Öffnungselement (50) eine zusätzliche Öffnung (52), durch die ein Teil des Lichts, das durch die Öffnung (42) hindurchgeht, hindurchgeht, und einen zusätzlichen Abschirmungsbereich (54), der zum Abschirmen des restlichen Teils von Licht, das durch die Öffnung (42) hindurchgeht, ausgelegt ist, aufweist und wobei der Teil von Licht, das durch die zusätzliche Öffnung (52) hindurchgeht, die Kamera (30) erreicht.

2. Bildgebungsvorrichtung (100) nach Anspruch 1, wobei das Öffnungselement (40) einen Abschirmungsbereich (44) umfasst, der das Licht, das von einer Vorderseite der Anzeige (20) zur Rückseite der Anzeige (20) hindurchgeht, abschirmt, wobei der Abschirmungsbereich (44) ein Abschnitt des Öffnungselements (40) ist, wo die Öffnung (42) nicht gebildet ist.

3. Bildgebungsvorrichtung (100) nach Anspruch 1 oder 2, wobei das Öffnungselement (40) aus mechanischen Teilen gebildet ist und die Öffnung (42) ein in den mechanischen Teilen definiertes Loch ist.

4. Bildgebungsvorrichtung (100) nach einem der Ansprüche 1 bis 3, wobei das Öffnungselement (40) über ein gehärtetes Haftmittel oder ein doppelseitiges Klebeband an der Rückfläche (28) der Anzeige (20) angebracht ist.

**5.** Bildgebungsvorrichtung (100) nach einem der Ansprüche 1 bis 3, wobei das Öffnungselement (40) direkt auf der Rückfläche (28) der Anzeige (20) gedruckt ist.

**6.** Bildgebungsvorrichtung (100) nach einem der Ansprüche 1 bis 5, wobei sich eine Membranposition (A') der optischen Linse (32) an einer Mitte der Öffnung (42) des Öffnungselements (40) befindet.

**7.** Bildgebungsvorrichtung (100) nach einem der Ansprüche 1 bis 6, wobei das Öffnungselement (40) von einer Vorderseite (36) beabstandet ist, die eine Oberfläche einer Vorderseite der Kamera (30) ist.

**8.** Bildgebungsvorrichtung (100) nach einem der Ansprüche 1 bis 5, wobei sich eine Membranposition (A') der optischen Linse (32) an einer Mitte der Öffnung (42) des Öffnungselements (40) befindet und eine Größe der zusätzlichen Öffnung (52) größer als eine Größe der Öffnung (42) ist oder sich eine Membranposition (A') der optischen Linse (32) an einer Mitte der zusätzlichen Öffnung (52) des zusätzlichen Öffnungselements (50) befindet und eine Größe der zusätzlichen Öffnung (52) kleiner als eine Größe der Öffnung (42) ist.

**9.** Bildgebungsvorrichtung (100) nach einem der Ansprüche 1 bis 8, wobei die Anzeige (20) ein Loch (20a) in einem Bereich entsprechend der Öffnung (42) des Öffnungselements (40) aufweist.

**10.** Bildgebungsvorrichtung (100) nach einem der Ansprüche 1 bis 9, wobei die Anzeige (20) einen Nichtanzeigebereich (26) ohne darin angeordnete elektrische Elemente aufweist und der Nichtanzeigebereich (26) der Öffnung (42) des Öffnungselements (40) entspricht.

**11.** Bildgebungsvorrichtung (100) nach einem der Ansprüche 1 bis 9, wobei die Anzeige (20) einen Nichtanzeigebereich (26) entsprechend der Öffnung (42) des Öffnungselements (40) aufweist und die Anzeige (20) eine Vielzahl von elektrischen Elementen umfasst und eine Anzeigefunktion der elektrischen Elemente in dem Nichtanzeigebereich (26) als Reaktion darauf, dass die Kamera (30) das Bild aufnimmt, ausgeschaltet ist.

**12.** Bildgebungsvorrichtung (100) nach einem der Ansprüche 1 bis 11, wobei die Kamera (30) in einem Mittelbereich der Anzeige (20) platziert ist.

**13.** Bildgebungsvorrichtung (100) nach einem der Ansprüche 1 bis 9, wobei die Anzeige (20) einen Nichtanzeigebereich (26) entsprechend der Öffnung (42) des Öffnungselements (40) aufweist und wobei die Bildgebungsvorrichtung (100) zumindest eine der folgenden Bedingungen erfüllt:

1) die Bedingung $d_L \geq D_d \geq d_A$, wobei ein effektiver Durchmesser einer kleinsten Linse der optischen Linse (32) $d_L$ ist, ein Durchmesser des Nichtanzeigebereichs (26) $D_d$ ist und ein Durchmesser der Öffnung (42) des Öffnungselements (40) $d_A$ ist,

2) die Bedingung
$$\frac{1}{2}D_d \geq T_d \tan \frac{1}{2}\theta_{60}$$
, wobei ein Blickwinkel bei einer Bildhöhe von 60 % $\theta_{60}$ ist und ein Abstand zwischen einer Mitte der Öffnung (42) und einer Vorderfläche (27), die eine Oberfläche einer Vorderseite der Anzeige (20) ist, $T_d$ ist, und

3) die Bedingung $S_1 \geq S_2$, wobei $S_1$ ein Abstand zwischen der Mitte der Öffnung (42) und einer Vorderfläche (38), die eine Oberfläche der Vorderseite der optischen Linse (32) ist und $S_2$ ein Abstand zwischen der Mitte der Öffnung (42) und der Rückfläche (28) der Anzeige (20) ist.

**14.** Elektronische Vorrichtung (10), **dadurch gekennzeichnet, dass** sie umfasst:

die Bildgebungsvorrichtung (100) nach einem der Ansprüche 1 bis 13 und einen Bildkorrekturprozessor (60), der zum Korrigieren des durch die Kamera (30) aufgenommenen Bilds ausgelegt ist.

**Revendications**

**1.** Dispositif d'imagerie (100), comprenant :

un dispositif d'affichage (20) ;
une caméra (30) située sur un côté arrière du dispositif d'affichage (20), la caméra (30) comprenant un objectif optique (32) et un capteur d'imagerie (34) servant à détecter la lumière traversant le dispositif d'affichage (20) pour capturer une image ; et
un élément d'ouverture (40) fixé à une surface arrière (28) qui est une surface du côté arrière du dispositif d'affichage (20), l'élément d'ouverture (40) ayant une ouverture (42) à travers laquelle la lumière issue du dispositif d'affichage (20) passe, de sorte que la lumière passant par l'ouverture (42) atteigne la caméra (30) ;
le dispositif d'imagerie (100) étant **caractérisé en ce qu'**il comprend un élément d'ouverture supplémentaire (50) sur une surface avant (36) qui est une surface d'un côté avant de la caméra (30), l'élément d'ouverture supplémentaire (50) ayant une ouverture supplémentaire (52) à travers laquelle une partie de la lumière traversant l'ouverture (42) passe et une zone écran supplémentaire (54) configurée pour faire écran à la partie restante de la lumière traversant l'ouverture (42), de sorte que la partie de la lumière passant par l'ouverture supplémentaire (52) atteigne la caméra (30) .

2. Dispositif d'imagerie (100) selon la revendication 1, dans lequel l'élément d'ouverture (40) comprend une zone écran (44) qui fait écran à la lumière passant d'un côté avant du dispositif d'affichage (20) au côté arrière du dispositif d'affichage (20), la zone écran (44) étant une partie de l'élément d'ouverture (40) dans laquelle l'ouverture (42) n'est pas formée.

3. Dispositif d'imagerie (100) selon la revendication 1 ou 2, dans lequel l'élément d'ouverture (40) est formé de pièces mécaniques, et l'ouverture (42) est un trou défini dans les pièces mécaniques.

4. Dispositif d'imagerie (100) selon l'une quelconque des revendications 1 à 3, dans lequel l'élément d'ouverture (40) est fixé à la surface arrière (28) du dispositif d'affichage (20) par l'intermédiaire d'un adhésif durci ou d'un ruban à double face.

5. Dispositif d'imagerie (100) selon l'une quelconque des revendications 1 à 3, dans lequel l'élément d'ouverture (40) est imprimé directement sur la surface arrière (28) du dispositif d'affichage (20).

6. Dispositif d'imagerie (100) selon l'une quelconque des revendications 1 à 5, dans lequel une position de diaphragme (A') de l'objectif optique (32) est située en un centre de l'ouverture (42) de l'élément d'ouverture (40).

7. Dispositif d'imagerie (100) selon l'une quelconque des revendications 1 à 6, dans lequel l'élément d'ouverture (40) est espacé d'une surface avant (36) qui est une surface d'un côté avant de la caméra (30).

8. Dispositif d'imagerie (100) selon l'une quelconque des revendications 1 à 5, dans lequel une position de diaphragme (A') de l'objectif optique (32) est située en un centre de l'ouverture (42) de l'élément d'ouverture (40), et une taille de l'ouverture supplémentaire (52) est supérieure à une taille de l'ouverture (42) ; ou une position de diaphragme (A') de l'objectif optique (32) est située en un centre de l'ouverture supplémentaire (52) de l'élément d'ouverture supplémentaire (50), et une taille de l'ouverture supplémentaire (52) est inférieure à une taille de l'ouverture (42).

9. Dispositif d'imagerie (100) selon l'une quelconque des revendications 1 à 8, dans lequel le dispositif d'affichage (20) comporte un trou (20a) dans une zone correspondant à l'ouverture (42) de l'élément d'ouverture (40).

10. Dispositif d'imagerie (100) selon l'une quelconque des revendications 1 à 9, dans lequel le dispositif d'affichage (20) comporte une zone sans affichage (26) ne contenant aucun élément électrique, et la zone sans affichage (26) correspond à l'ouverture (42) de l'élément d'ouverture (40).

11. Dispositif d'imagerie (100) selon l'une quelconque des revendications 1 à 9, dans lequel le dispositif d'affichage (20) comporte une zone sans affichage (26) correspondant à l'ouverture (42) de l'élément d'ouverture (40), et le dispositif d'affichage (20) comporte une pluralité d'éléments électriques, et une fonction d'affichage des éléments électriques de la zone sans affichage (26) est désactivée en réponse au fait que la caméra (30) capture l'image.

12. Dispositif d'imagerie (100) selon l'une quelconque des revendications 1 à 11, dans lequel la caméra (30) est placée dans une zone intermédiaire du dispositif d'affichage (20).

13. Dispositif d'imagerie (100) selon l'une quelconque des revendications 1 à 9, dans lequel le dispositif d'affichage (20) comporte une zone sans affichage (26) correspondant à l'ouverture (42) de l'élément d'ouverture (40), et
le dispositif d'imagerie (100) satisfaisant à au moins une des conditions suivantes :

1) la condition $d_L \geq D_d \geq d_A$, dans laquelle un diamètre effectif d'un plus petit objectif de l'objectif optique (32) est $d_L$, un diamètre de la zone sans affichage (26) est $D_d$, et un diamètre de l'ouverture (42) de l'élément d'ouverture (40) est $d_A$,

2) la condition $$\frac{1}{2}D_d \geq T_d \tan \frac{1}{2}\theta_{60},$$ dans laquelle un angle de vision à une hauteur d'image de 60 % est $\theta_{60}$ et une distance entre un centre de l'ouverture (42) et une surface avant (27) qui est une surface d'un côté avant du dispositif d'affichage (20) est $T_d$, et

3) la condition $S_1 \geq S_2$, dans laquelle $S_1$ est une distance entre le centre de l'ouverture (42) et une surface avant (38) qui est une surface du côté avant de l'objectif optique (32) et $S_2$ est une distance entre le centre de l'ouverture (42) et la surface arrière (28) du dispositif d'affichage (20).

14. Dispositif électronique (10), **caractérisé en ce qu'**il comprend :

le dispositif d'imagerie (100) selon l'une quelconque des revendications 1 à 13 ; et
un processeur de correction d'image (60), configuré pour corriger l'image capturée par la caméra (30).

II ←

30

10

FIG. 1

10

30

32  34

40  44

22

20

24

42

44

28

FRONT

BACK

FIG. 2

FIG. 3

FIG. 4

FIG. 5

$$d_L \geq D_d \geq d_A \quad \text{and / or} \quad \frac{1}{2}D_d \geq T_d \tan\frac{1}{2}\theta_{60} \quad \text{and / or} \quad S_1 \geq S_2$$

FIG. 6

EP 4 066 477 B1

$$d_L \geq D_d \geq d_A \quad \text{and / or} \quad \frac{1}{2}D_d \geq T_d \tan\frac{1}{2}\theta_{60} \quad \text{and / or} \quad S_1 \geq S_2$$

FIG. 7

$$d_L \geq D_d \geq d_A \quad \text{and / or} \quad \frac{1}{2}D_d \geq T_d \tan\frac{1}{2}\theta_{60} \quad \text{and / or} \quad S_1 \geq S_2$$

FIG. 8

EP 4 066 477 B1

FIG. 9

**EP 4 066 477 B1**

**Patent documents cited in the description**

- US 2008106628 A1
- US 2017140221 A1
- US 2014192257 A1